# EUROPEAN PATENT APPLICATION

(11) **EP 2 722 940 A1**
(43) Date of publication of application: **23.04.2014**
(21) Application number: 12800053.6
(22) Date of filing: 15.06.2012
(51) Int. Cl.: H01R 31/06, H01R 13/66, H01R 13/719

(54) **AUDIO SIGNAL ADAPTER DEVICE**

(30) Priority: 15.06.2011 CN 201110161193
(71) Applicant: Tendyron Corporation, Beijing 100083 (CN)
(72) Inventor: LI, Dongsheng, Beijing 100083 (CN)
(74) Representative: Maiwald Patentanwalts GmbH
(86) International application number: PCT/CN2012/077040
(87) International publication number: WO 2012/171495

(57) **Abstract**

An audio signal adapter device comprising: an input port, an output port, a boost converter unit, a rectifier unit, and a filter unit. The input port comprises an audio pin used for receiving an audio signal and for outputting to the boost converter unit the audio signal received. The boost converter unit is used for boosting the audio signal inputted and for outputting to the rectifier unit the audio signal boosted. The rectifier unit is used for rectifying the audio signal boosted, and for outputting to an input end of the filter unit a level acquired via the rectification. The filter unit is used for filtering the level inputted, and for outputting to a power pin of the output port a direct current level acquired via the filtration. The output port also comprise an audio signal pin, which is connected to the audio pin of the input port or to an output end of the boost converter unit, a reference signal pin, and a ground pin connected thereto.

## Description

### FIELD

The present invention generally relates to an electronic technical field, and more particularly relates to an audio signal adapter device.

### BACKGROUND

With the development of an audio signal coding/decoding technology, more and more electronic equipments transmitting data via an audio interface are produced. For example, the electronic equipment may be connected with a mobile communication device (such as a mobile phone) via a headphone plug of the mobile communication device for receiving an audio signal output from the mobile communication device.

As an output power of the headphone plug is usually very low, except the electronic equipment (such as a headphone) with low power consumption, the electronic equipment receiving the audio signal via the headphone plug generally needs to use an external power source or an internal battery for normal working, which increases a cost of the electronic equipment and enlarges a size of the electronic equipment.

### SUMMARY

The technical problem to be solved by the present disclosure is to overcome the defects of the prior art, and to provide an audio signal adapter device which can output a relatively high power.

To solve the above problem, the present disclosure provides an audio signal adapter device, comprising an input interface, an output interface, a boosting unit, a rectifying unit and a filtering unit.

The input interface comprises at least one audio pin configured to receive an audio signal output from an audio signal sending device. The at least one audio pin of the input interface outputs the audio signal to an input end of the boosting unit.

The boosting unit is configured to boost a voltage of the audio signal, and to output a boosted audio signal to an input end of the rectifying unit via an output end thereof.

The rectifying unit is configured to rectify the boosted audio signal to obtain a rectified level, and to output the rectified level to an input end of the filtering unit via an output end thereof.

The filtering unit is configured to filter the rectified level to obtain a direct current level, and to output the direct current level to a power pin of the output interface via output end thereof.

The output interface further comprises an audio signal pin, the audio signal pin is connected with the at least one audio pin of the input interface or the output end of the boosting unit.

The output interface further comprises a reference signal pin, the input interface further comprises a ground pin, and the reference signal pin is connected with the ground pin.

Furthermore, the boosting unit is a boosting transformer, and the boosting transformer comprises a primary coil and a secondary coil.

A first pin of the primary coil is used as the input end of the boosting unit to be connected with the at least one audio pin, and a second pin of the primary coil is grounded.

At least one output pin of the secondary coil is used as the output end of the boosting unit to be connected with the input end of the rectifying unit, and a tap of the secondary coil is grounded.

Furthermore, the rectifying unit comprises at least one diode, an anode of the at least one diode is connected with the input end of the rectifying unit, and a cathode of the at least one diode is connected with the output end of the rectifying unit.

Furthermore, the secondary coil of the boosting transformer comprises two output pins, and the input end of the rectifying unit comprises two input pins.

The two output pins of the secondary coil are connected with the two input pins of the rectifying unit respectively;

The rectifying unit comprises two diodes, and anodes of the two diodes are connected with the two input pins of the rectifying unit respectively.

Furthermore, the filtering unit comprises a capacitor.

A first end of the capacitor is connected with the input end or the output end of the rectifying unit.

The input end of the rectifying unit is connected with the output end of the rectifying unit.

Furthermore, the boosting unit is a boosting transformer, and the boosting transformer comprises a primary coil and a secondary coil.

A first pin of the primary coil is used as the input end of the boosting unit to connected with the at least one audio pin, and a second pin of the primary coil is grounded.

A first output pin of the secondary coil is used as the output end of the boosting unit to be connected with the input end of the rectifying unit, and a second output pin of the secondary coil is grounded.

Furthermore, the rectifying unit comprises one diode, an anode of the diode is connected with the input end of the rectifying unit, and a cathode of the diode is connected with the output end of the rectifying unit.

Furthermore, the second pin of the primary coil is connected with the ground pin of the input interface.

Furthermore, the output interface is a USB output interface.

The power pin is a VBUS pin of the USB output interface.

The audio signal pin is one of a D+ pin and a D- pin of the USB output interface, and the reference signal pin is the other one of the D+ pin and the D- pin of the USB output interface.

Furthermore, the first pin of the primary coil is connected with the at least one audio pin via a resistor.

Furthermore, the input interface comprises two audio pins: a left-channel pin and a right-channel pin.

Furthermore, one of the left-channel pin and the right-channel pin is configured to output the audio signal to the input end of the boosting unit, and the other one of the left-channel pin and the right-channel pin is configured to be connected with the audio signal pin of the output interface.

In conclusion, the present disclosure realizes a feeding function via the audio signal with a low hardware cost. When the electronic equipment is used together with the audio signal adapter device (such as an audio cable) according to the present disclosure, it can obtain electric energy while receiving the audio signal, thus reducing a cost of the electronic equipment and decreasing a size of the electronic equipment.

Furthermore, the audio signal adapter device according to the present disclosure may further comprise a USB plug, and thus it can be inserted into a USB socket of the electronic equipment (an audio signal receiving device), then the electronic equipment can obtain power via the VBUS pin and can use one of the D+ pin and the D- pin as the audio signal pin (the pin corresponding to a left-channel audio signal, a right-channel audio signal, a mono audio signal or a hybrid channel audio signal) and use the other one of the D+ pin and the D- pin as the ground pin (or referred to as the reference signal pin), so as to receive the audio signal output from a headphone jack of an audio signal sending device.

### BRIEF DESCRIPTION OF THE DRAWINGS

Fig. 1 is a schematic diagram of an audio adapter device according to a first embodiment of the present disclosure;
Fig. 1a shows a schematic diagram of an audio signal receiving module in an audio signal receiving device connected with the audio signal adapter device according to the first embodiment of the present disclosure, in which the audio signal receiving module is configured to receive a differential signal;
Fig. 2 is a schematic diagram of a variation of the audio signal adapter device according to the first embodiment of the present disclosure, in which the D+ pin and the D- pin are exchanged relative to the D+ pin and the D- pin shown in Fig. 1;
Fig. 3 is a schematic diagram of a variation of the audio signal adapter device according to the first embodiment of the present disclosure, in which a left-channel pin is connected with a primary coil of a boosting transformer, and a right-channel pin is only connected with the D+ pin;
Fig. 4 is a schematic diagram of an audio signal adapter device according to a second embodiment of the present disclosure;
Fig. 5 is a schematic diagram of an audio signal adapter device according to an embodiment of the present disclosure, in which an audio signal pin is connected with an output pin of a boosting transformer;
Fig. 6 is a schematic diagram of an audio signal adapter device according to an embodiment of the present disclosure, in which an output interface of the audio signal adapter device is replaced by other types of interfaces having a power pin, an audio signal pin, a reference signal pin, and a ground pin.

### DETAILED DESCRIPTION

In the following, the present disclosure will be described in detail with reference to drawings and embodiments.

The audio signal adapter device in the present disclosure may be an audio cable, an audio adapter cable or an audio adapter.

### FIRST EMBODIMENT

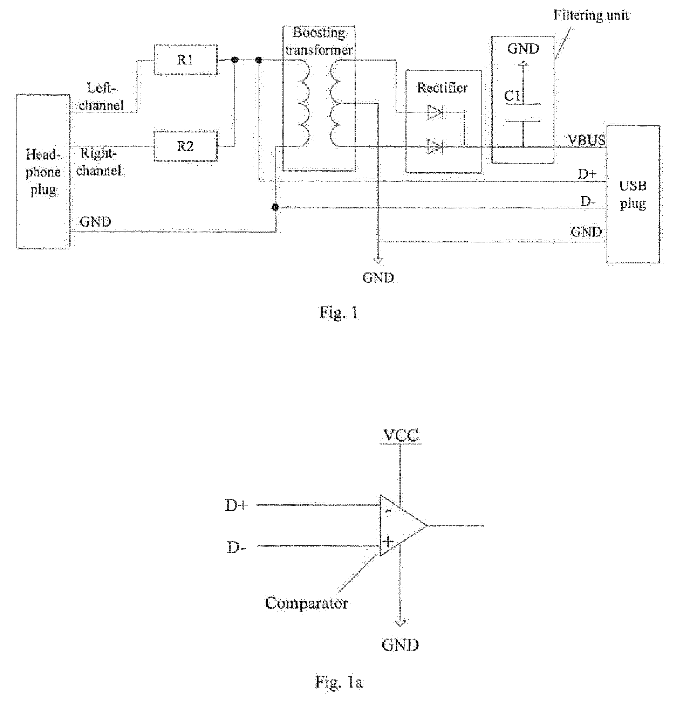

Fig. 1 is a schematic diagram of an audio signal adapter device according to a first embodiment of the present disclosure. As shown in Fig. 1, the audio signal adapter device comprises a headphone plug, a boosting unit (such as a boosting transformer shown in Fig. 1), a rectifying unit (such as a rectifier shown in Fig. 1), a filtering unit and a USB plug.

The headphone plug is configured to be connected with a headphone jack of an audio signal sending device (such as a mobile phone) and to receive an audio signal output from the audio signal sending device.

The headphone plug comprises a left-channel pin, a right-channel pin and a ground pin.

The left-channel pin and the right-channel pin are connected with a same pin of a primary coil of the boosting transformer, and the ground pin of the headphone plug is connected with the other pin of the primary coil of the boosting transformer.

Alternatively, in order to reduce the power consumption of the audio signal sending device, a resistor R1 may be connected in series between the left-channel pin and the boosting transformer, and a resistor R2 may be connected in series between the right-channel pin and the boosting transformer. In this embodiment, a resistance of the resistor R1 is equal to that of the resistor R2.

Furthermore, the ground pin of the headphone plug is also connected with the D- pin of the USB plug.

The boosting transformer, comprising a primary coil and a secondary coil, is configured to boost an input voltage (generally about 1V) at an input end (the primary coil) to an output voltage (for example, greater than or equal to 5V) at an output end (the secondary coil).

As described above, the primary coil of the boosting transformer comprises two pins, one pin is connected with the left-channel pin and the right-channel pin of the headphone plug respectively, and the other pin is connected with the ground pin of the headphone plug.

The secondary coil of the boosting transformer comprises two output pins and one tag, the two output pins are connected with the two input pins of an input end in the rectifier respectively, and the tag is connected with the ground pin of the USB plug.

The rectifier is configured to rectify an alternating current level input from the input end to obtain a rectified level, and to output the rectified level via an output end.

In this embodiment, the rectifier comprises two input pins of the input end and one output pin of the output end. Correspondingly, the rectifier comprises two diodes, anodes of the two diodes are connected with the two input pins of the rectifier respectively, and cathodes of the two diodes are connected with the output pin of the rectifier.

The filtering unit, comprising an input end and an input end, is configured to convert the rectified level input from the input end into a smooth direct current level and to output the smooth direct current level via the output end.

In this embodiment, the input end of the filtering unit is connected with the output end of the rectifier, and the output end of the filtering unit is connected with the VBUS pin (the power pin) of the USB plug, thus the electronic equipment connected with the USB plug is supplied with power via the VBUS pin.

In this embodiment, the input end of the filtering unit is connected with the output end of the filtering unit. The filtering unit further comprises a capacitor C1. One end of the capacitor C1 is connected with the input/output end, and the other end of the capacitor C1 is grounded.

Furthermore, the left-channel pin and the right-channel pin of the headphone plug are also connected with the D+ pin of the USB plug.

When the audio signal adapter device according to the first embodiment of the present disclosure is used together with an electronic equipment, the headphone plug of the audio signal adapter device may be inserted into a headphone jack of an audio signal sending device (such as the mobile phone), and the USB plug of the audio signal adapter device may be inserted into the USB socket of the electronic equipment. Such that, the electronic equipment can obtain power via the VBUS pin of the USB plug/socket (collectively known as the USB output interface), meanwhile, use the D+ pin as the audio signal pin and use the D- pin as the reference signal pin so as to receive the audio signal output from the headphone jack of the audio signal sending device.

Furthermore, Fig. 1a shows a schematic diagram of an audio signal receiving module in an audio signal receiving device connected with the audio signal adapter device according to the first embodiment of the present disclosure. The audio signal receiving module is configured to receive a differential signal.

As shown in Fig. 1a, the audio signal receiving module comprises a comparator, a positive terminal of the comparator is connected with the D+ pin of the USB plug, a negative terminal of the comparator is connected with the D- pin of the USB plug, a ground pin of the comparator is grounded, a power pin of the comparator is connected with a power supply, and an output pin of the comparator is configured to output a square wave corresponding to the input audio signal.

According to the basic principle of the present disclosure, many alternatives and modifications may be made to the above embodiments as follows.

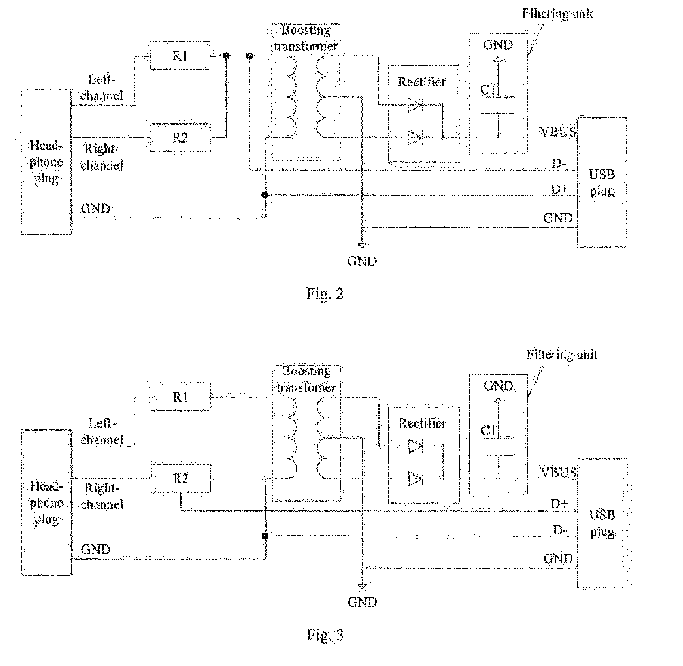

As shown in Fig. 2, in other embodiments of the present disclosure, it is also possible to use the D- pin of the USB output interface as the audio signal pin, and to use the D+ pin of the USB output interface as the reference signal pin.

As shown in Fig. 3, in other embodiments of the present disclosure, it is also possible to connect only one audio pin (for example, the left-channel pin) of the headphone plug with the primary coil of the boosting transformer, and to connect the other audio pin (for example, the right-channel pin) of the headphone plug with only the D+ pin of the USB plug.

Certainly, when the electronic equipment only needs to receive the audio data of one channel, it is also possible for the audio signal adapter device shown in Fig. 3 not to use the right-channel pin.

### SECOND EMBODIMENT

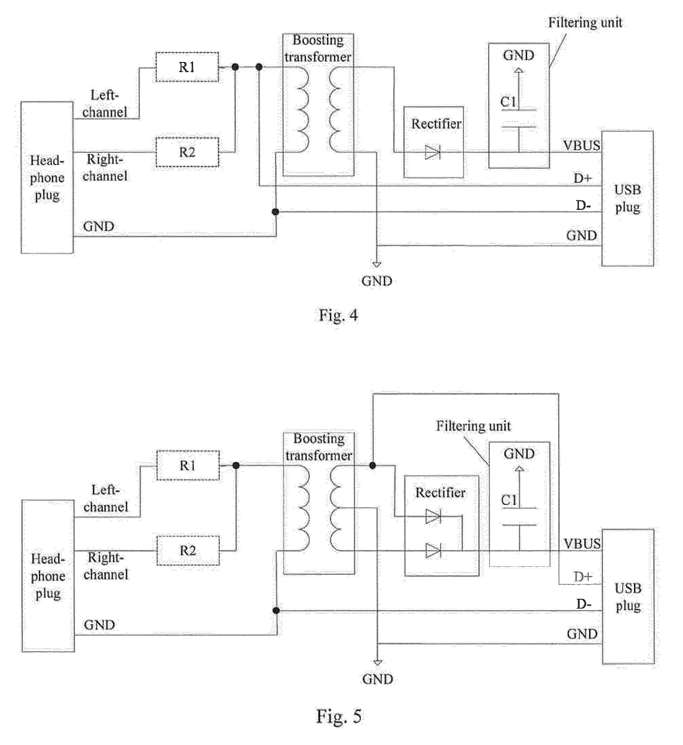

Fig. 4 is a schematic diagram of an audio signal adapter device according to a second embodiment of the present disclosure. As shown in Fig. 4, the differences between the second embodiment and the first embodiment are as follows.

In this embodiment, only one output pin of the secondary coil of the boosting transformer, is connected with the input pin of the rectifier, thus the rectifier only has to comprise one input pin and one diode.

Apparently, compared with the first embodiment, a half of electric energy of the secondary coil of the boosting transformer, will be lost if using the audio signal adapter device in the second embodiment. However, a circuit structure of the audio signal adapter is simplified, thus a hardware cost is reduced.

In this embodiment, the other output pin of the secondary coil of the boosting transformer is grounded, and the boosting transformer does not comprise a tag.

The above embodiments of the present disclosure realize a feeding function via the audio signal with a low hardware cost. When the electronic equipment is used together with the audio signal adapter device (such as an audio cable) according to the present disclosure, it can obtain electric energy while receiving the audio signal, thus reducing a cost of the electronic equipment and decreasing a size of the electronic equipment.

Furthermore, since the audio signal adapter device according to the present disclosure comprises the USB plug, it can be inserted into the USB socket of the electronic equipment (the audio signal receiving device), and then the electronic equipment can obtain power via the VBUS pin and can use one of the D+ pin and the D- pin as the audio signal pin (the pin corresponding to a left-channel audio signal, a right-channel audio signal, a mono audio signal or a hybrid channel audio signal) and use the other one of the D+ pin and the D- pin as the ground pin (or referred to as the reference signal pin) so as to receive the audio signal output from the headphone jack of the audio signal sending device.

Certainly, according to the basic principle of the present disclosure, the headphone plug in the above embodiments may be replaced with other types of input interfaces having an audio pin (a left-channel pin, a right-channel pin and a mono pin) and a ground pin (a reference signal pin).

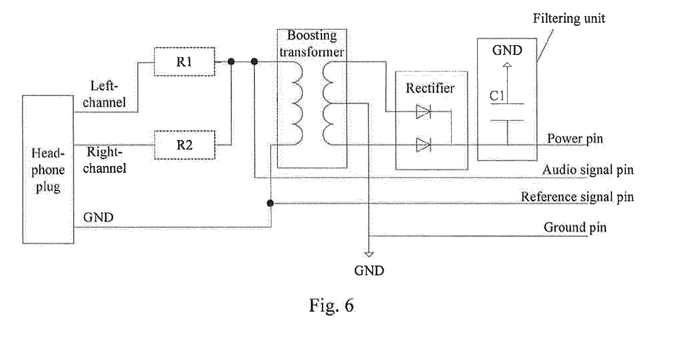

Furthermore, as shown in Fig. 6, the USB plug in the above embodiments may be replaced with other types of output interfaces having a power pin, an audio signal pin, a reference signal pin and a ground pin.

Furthermore, the output interface of the above embodiments may comprise two output interfaces, which are a power output interface (may comprise a power pin and a ground pin) and an audio signal output interface (may comprise an audio signal pin and a reference signal pin).

Furthermore, the above input interface may be fixed connected with the audio signal sending device.

Furthermore, the above output interface may be fixed connected with the electronic equipment (the audio signal receiving device).

The above input interface may comprise a plurality of plugs, such as an audio signal plug having an audio signal input pin and a MIC plug having a MIC pin.

Furthermore, as shown in Fig. 5, the audio signal pin of the output interface may be connected with the output pin of the boosting transformer for outputting the audio signal.

## Claims

1. An audio signal adapter device, comprising an input interface and an output interface, wherein the audio signal adapter device further comprises a boosting unit, a rectifying unit and a filtering unit;
the input interface comprises at least one audio pin configured to receive an audio signal output from an audio signal sending device, and the at least one audio pin of the input interface outputs the audio signal to an input end of the boosting unit;
the boosting unit is configured to boost a voltage of the audio signal, and to output a boosted audio signal to an input end of the rectifying unit via an output end thereof;
the rectifying unit is configured to rectify the boosted audio signal to obtain a rectified level, and to output the rectified level to an input end of the filtering unit via an output end thereof;
the filtering unit is configured to filter the rectified level to obtain a direct current level, and to output the direct current level to a power pin of the output interface via output end thereof;
the output interface further comprises an audio signal pin, the audio signal pin is connected with the at least one audio pin of the input interface or the output end of the boosting unit;
the output interface further comprises a reference signal pin, the input interface further comprises a ground pin, and the reference signal pin is connected with the ground pin.

2. The audio signal adapter device according to claim 1, wherein
the boosting unit is a boosting transformer, and the boosting transformer comprises a primary coil and a secondary coil;
a first pin of the primary coil is used as the input end of the boosting unit to be connected with the at least one audio pin, and a second pin of the primary coil is grounded;
at least one output pin of the secondary coil is used as the output end of the boosting unit to be connected with the input end of the rectifying unit, and a tap of the secondary coil is grounded.

3. The audio signal adapter device according to claim 2, wherein
the rectifying unit comprises at least one diode, an anode of the at least one diode is connected with the input end of the rectifying unit, and a cathode of the at least one diode is connected with the output end of the rectifying unit.

4. The audio signal adapter device according to claim 3, wherein
the secondary coil of the boosting transformer comprises two output pins; and
the input end of the rectifying unit comprises two input pins;
the two output pins of the secondary coil are connected with the two input pins of the rectifying unit respectively;
the rectifying unit comprises two diodes, and anodes of the two diodes are connected with the two input pins of the rectifying unit respectively.

5. The audio signal adapter device according to claim 1, wherein
the filtering unit comprises a capacitor;
a first end of the capacitor is connected with the input end or the output end of the rectifying unit;
the input end of the rectifying unit is connected with the output end of the rectifying unit.

6. The audio signal adapter device according to claim 1, wherein
the boosting unit is a boosting transformer, and the boosting transformer, comprises a primary coil and a secondary coil;
a first pin of the primary coil is used as the input end of the boosting unit to connected with the at least one audio pin, and a second pin of the primary coil is grounded;
a first output pin of the secondary coil is used as the output end of the boosting unit to be connected with the input end of the rectifying unit, and a second output pin of the secondary coil is grounded.

7. The audio signal adapter device according to claim 6, wherein
the rectifying unit comprises one diode, an anode of the diode is connected with the input end of the rectifying unit, and a cathode of the diode is connected with the output end of the rectifying unit.

8. The audio signal adapter device according to claim 2, wherein
the second pin of the primary coil is connected with the ground pin of the input interface.

9. The audio signal adapter device according to claim 1, wherein
the output interface is a USB output interface;
the power pin is a VBUS pin of the USB output interface;
the audio signal pin is one of a D+ pin and a D- pin of the USB output interface, and the reference signal pin is the other one of the D+ pin and the D- pin of the USB output interface.

10. The audio signal adapter device according to claim 2 or 6, wherein
the first pin of the primary coil is connected with the at least one audio pin via a resistor.

11. The audio signal adapter device according to claim 1, wherein
the input interface comprises two audio pins: a left-channel pin and a right-channel pin.

12. The audio signal adapter device according to claim 11, wherein
one of the left-channel pin and the right-channel pin is configured to output the audio signal to the input end of the boosting unit, and the other one of the left-channel pin and the right-channel pin is configured to be connected with the audio signal pin of the output interface.
